# EUROPÄISCHE PATENTSCHRIFT

(11) **EP 2 695 257 B1**
(45) Veröffentlichungstag und Bekanntmachung des Hinweises auf die Patenterteilung: **27.07.2016**
(21) Anmeldenummer: 12713040.9
(22) Anmeldetag: 27.03.2012
(51) Int. Cl.: H02B 1/28, F16J 12/00, H01H 9/04

(54) **DRUCKFESTES GEHÄUSE**
PRESSURE-RESISTANT HOUSING
BOÎTIER RÉSISTANT À LA PRESSION

(30) Priorität: 01.04.2011 DE 102011001723
(43) Veröffentlichungstag der Anmeldung: 12.02.2014
(73) Patentinhaber: Konecranes Global Corporation, 05830 Hyvinkää (FI)
(72) Erfinder: MACK, Wilhelm, 74653 Dörrenzimmern (DE); GRÜBEL, Willy, 74214 Schöntal-Sindeldorf (DE); KAPP, Tatjana, 74623 Öhringen (DE); WULFF, Andreas, 74653 Künzelsau (DE); HESS, Wilfried, 74405 Gaildorf (DE)
(74) Vertreter: Rüger, Barthelt & Abel
(86) Internationale Anmeldenummer: PCT/EP2012/055418
(87) Internationale Veröffentlichungsnummer: WO 2012/130849

(56) Entgegenhaltungen:
- EP-A2- 0 452 778
- DE-A1- 1 801 062

## Beschreibung

Die Erfindung betrifft ein Gehäuse druckfester Bauart, sowie ein Verfahren zur Herstellung desselben.

In explosionsgefährdeter Umgebung betriebene Einrichtungen, die Zündquellen enthalten oder bilden können, müssen so eingehaust sein, dass gefahrloser Betrieb möglich ist. Dazu sind druckfeste Gehäuse in Gebrauch, die selbst dann, wenn in das Gehäuse eingedrungenes explosionsfähiges Gasgemisch zündet, die entstehende Verpuffung sicher einschließen, so dass weder Flammen noch glühende Partikel nach außen gelangen können.

Die DE 40 18 205 C2 offenbart ein solches druckfestes Gehäuse, das aus mehreren untereinander verbundenen Teilen zusammengesetzt ist. Es besteht aus miteinander verschweißten Platten, wobei an einer der Platten ein schwenkbar gelagerter Deckel vorgesehen ist.

Die DE 2006 013 017 A1 schlägt ein hermetisch dichtes Gehäuse vor, das aus zwei Teilen, nämlich einem becherartigen Teil und einem deckelartigen Teil, besteht. Die beiden Teile sind miteinander verschraubt. Sie sind als Gussteile ausgebildet.

Die DE 21 12 224 C3 schlägt ein explosionsgeschütztes Gehäuse der Schutzart druckfeste Kapselung (ex-d) vor, dass als zylindrischer Kessel mit gerundetem Deckel und Boden ausgebildet ist. Der Deckel ist mit dem becherartigen anderen Gehäuseteil verschraubt.

Die DE 30 35 835 offenbart ein druckfestes Gehäuse quaderförmiger Gestalt zur explosionssicheren Kapselung elektrischer Geräte. Es weist eine rechteckige Öffnung und einen rechteckigen Deckel auf, der über Schwenkarme schwenkbar und verschiebbar am Gehäuse befestigt ist. Durch Verschlusselemente kann er in Schließstellung gesichert werden.

Ein ähnliches Gehäuse ist aus der DE 1 170 890 bekannt.

Aus der EP 0 452 778 A2 ist ein Druck- oder Vakuumgefäß und ein Herstellungsverfahren für dieses bekannt. Das Gefäß besteht aus zwei mit Durchbrüchen versehenen jeweils U-förmigen gebogenen Blechen, die passend ineinander gefügt und dann entlang der Kanten miteinander verschweißt sind. Die entlang der Kanten verlaufenden Schweißnähte verbinden jeweils immer zwei Blechränder miteinander. Stellen, an denen sich drei oder mehrere Bleche treffen, existieren nicht. Deswegen eignet sich das Fertigungsprinzip für Vakuum- oder Druckgefäße, die, falls Lecks auftreten, relativ leicht zu reparieren sind.

Zur Herstellung von Gehäusekörpern verweist die DE 1 801 062 darauf, ein Gehäuse aus Stahlblechteilen auszubilden, die durch Schweißen verbunden sind. Die Seitenwände können durch eingeschweißte Platten verstärkt werden. Vorderwand und Rückwand können durch abgewinkelte Blechteile ausgebildet werden, deren freie Schenkel den Bereich der Seitenwände übergreifen. Dabei können die an den Seiten eingeschweißten Platten eine größere Dicke als Vorder- und Rückseite des Gehäuses aufweisen.

Die Herstellung eines explosionsgeschütztes Gehäuses stellt sich insgesamt als aufwendiger Prozess dar. Es wird deshalb nach einem Konzept gesucht, mit dem sich explosionsgeschützte Gehäuse einfach und prozesssicher möglichst automatisiert herstellen lassen.

Diese Aufgabe wird mit dem Gehäuse nach Anspruch 1 gelöst. Außerdem ist das Verfahren nach Anspruch 11 zur Herstellung eines solchen Gehäuses vorteilhaft.

Das erfindungsgemäße Gehäuse der Zündschutzart druckfeste Kapselung (ex-d) besteht aus zwei vorzugsweise u-förmigen, ineinander greifenden Gehäuseschalen, die untereinander durch eine in sich geschlossene, unverzweigte, endlose Schweißnaht verbunden sind. Beim Herstellen der Schweißnaht trifft der Punkt der Schweißnaht an dem der Schweißvorgang beendet wird denjenigen Punkt der Schweißnaht, bei dem der Schweißvorgang begonnen worden ist. Somit bildet die Schweißnaht einen räumlichen geschlossenen Ring. Im Fall eines quaderförmigen Gehäuses schließt die Schweißnaht acht an einander anschließende Gehäusekanten. Davon vorzugsweise zwei am Boden, zwei oben und vier an den Seiten.

Vorzugsweise bestehen die beiden Gehäuseschalen jeweils aus einem Grundabschnitt, von dem zwei einander gegenüber liegende Seiten zur gleichen Richtung hin gebogen sind. Jede Gehäuseschale ist deshalb in Seitenansicht etwa U-förmig ausgebildet. Der Winkel, mit dem die Seitenabschnitte gegen den Grundabschnitt gebogen sind, betragen vorzugsweise 90°. Abweichende Winkel sind möglich, wenn nicht quaderförmige Gehäuse gewünscht sind. Im Fall eines quaderförmigen Gehäuses wird zur Herstellung der Gehäuseschalen von rechteckigen Blechzuschnitten mit gerundeten Ecken ausgegangen. Die Biegezonen, an denen die Seitenabschnitte in den Grundabschnitt übergehen, sind vorzugsweise gerade, streifenförmige, zueinander parallele Bereiche.

Die Grundabschnitte sowie die Seitenabschnitte der Gehäuseschalen können als ebene Flächenbereiche ausgebildet sein. Es können jedoch auch Wölbungen oder zusätzliche Biegelinien vorgesehen werden, wenn von der Quaderform abweichende Gehäuse erzeugt werden sollen.

Die Grundabschnitte jeder Gehäuseschale bilden mit den beiden Seitenabschnitte Maulöffnungen. Jede Maulöffnung wird von einem Seitenabschnitt der jeweils anderen Gehäuseschale geschlossen. Die Schweißnaht erstreckt sich entlang des Randes aller Maulöffnungen.

Zur Ausbildung der Gehäuseschalen wird vorzugsweise relativ dickwandiges Stahlblech genutzt. Die Wandstärke liegt vorzugsweise im Bereich mehrerer Millimeter, bspw. zwischen 5 mm und 30 mm, bspw. beträgt die Blechstärke 12 mm, 15 mm oder 20 mm. Es ergeben sich an den Rändern jeder Gehäuseschale streifenförmige Stirnflächen, an denen die Schweißnaht angeordnet wird. Dabei läuft die Schweißnaht entlang der gesamten Länge jeder streifenförmigen Stirnfläche jeder Gehäuseschale. Vorzugsweise ist die Schweißnaht als Kehlnaht ausgebildet.

Das Gehäuse weist vorzugsweise gerundete Biegekanten (d.h. Biegezonen) auf. Die Rundung der Ecken der einzelnen

Seitenteile stimmt dabei vorzugsweise mit der Rundung der Biegekante überein. Die Schweißnaht weist somit entlang ihres Verlaufs keine spitzen Ecken auf, wodurch die Herstellung in hoher Qualität automatisierbar ist.

Das Gehäuse kann mindestens einen verschlossenen oder verschließbaren Durchbruch aufweisen. Vorzugsweise ist ein an dem Durchbruch vorgesehener Deckel z.B. teilweise in den Durchbruch eingesetzt oder so auf den Durchbruch aufgesetzt, dass sich eine gewünschte Mindestspaltlänge von bspw. 25 mm ergibt. Ist der Deckel in den Durchbruch eingeschraubt kann die nötige Spaltlänge durch das Gewinde auch dann erzielt werden, wenn die Wandstärke geringer ist als die gewünschte Spaltlänge von z.B. 25 mm.

Das Gehäuse kann mit einem weiteren Gehäuse anderer Zündschutzart verbunden sein, beispielsweise kann dies ein ex-e Gehäuse sein.

Weitere Einzelheiten vorteilhafter Ausführungsformen der Erfindung sind Gegenstand von Unteransprüchen, der Beschreibung oder der Zeichnung. Es zeigen:
Figur 1 ein erfindungsgemäßes explosionsgeschütztes Gehäuse der Bauart druckfeste Kapselung mit einem angebauten Gehäuse anderer Schutzart, in perspektivische Darstellung.
Figur 2 das explosionsgeschützte Gehäuse nach Figur 1, in einer separaten anderweitigen perspektivischen Ansicht,
Figur 3 ein Gehäuse gemäß Figur 2 in leicht abgewandelter Form, in perspektivischer Explosionsdarstellung zur Veranschaulichung seiner Einzelteile,
Figur 4 das Gehäuse nach Figur 3, in schematisierter durchsichtiger perspektivischer Darstellung zur Veranschaulichung des Verlaufs seiner Schweißnaht,
Figur 5 einen Eckbereich des Gehäuses nach Figur 1 bis 4,
Figur 6 das Gehäuse nach Figur 3, in einer ausschnittsweisen Detaildarstellung,
Figur 7 eine Prinzipdarstellung des Gehäuses nach Figur 1,
Figur 8 und 9 Durchführungsanordnungen an dem Gehäuse nach Figur 7, in schematischer Längsschnittdarstellung,
Figur 10 einen Gerätefuß des erfindungsgemäßen Gehäuses, in Schnittdarstellung und
Figur 11 eine abgewandelte Ausführungsform eines erfindungsgemäßen Gehäuses, in schematisierte Explosionsdarstellung.

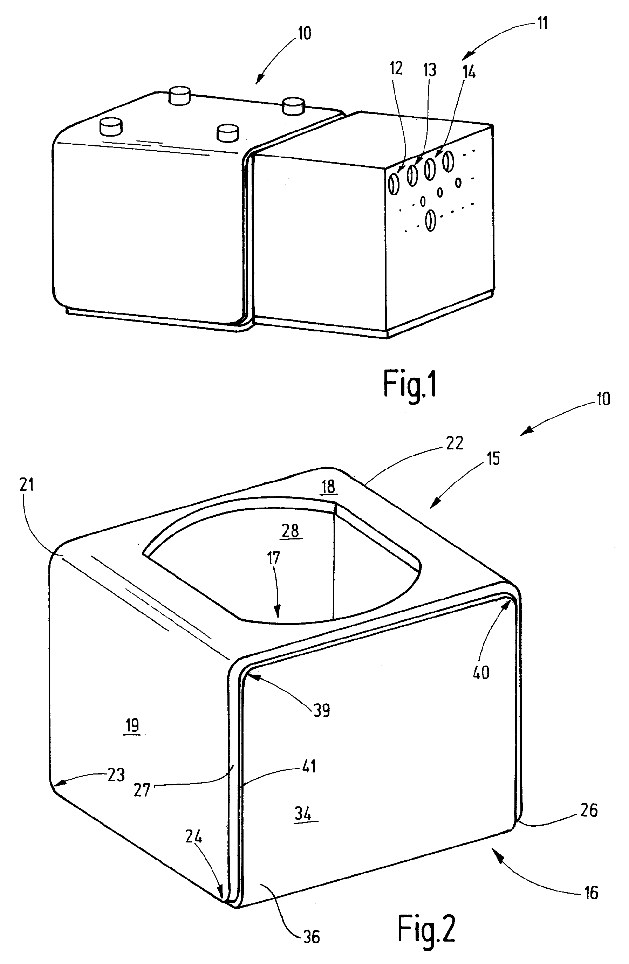

In Figur 1 ist ein Gehäuse 10 in der Bauart druckfeste Kapselung (ex-d) veranschaulicht, das z.B. eine elektrische Schaltung enthalten kann. Die Elemente dieser elektrischen Schaltung, z.B. Kondensatoren, Relais, Schalter, Transistoren, Widerstände, Schaltkreise, Sicherungen oder dergleichen können Zündquellen darstellen oder zumindest im Fehlerfalle Zündquellen ausbilden. Das Gehäuse 10 schließt diese explosionssicher ein. Das Gehäuse 10 kann z.B. die Steuerung eines Hebezeugs oder dergleichen beherbergen. Im vorliegenden Beispiel ist das Gehäuse 10 mit einem weiteren Gehäuse 11 verschraubt. Dieses kann bspw. Anschlussklemmen oder dergleichen beherbergen, d.h. Elemente, die keine Zündquelle bilden. Die Bauart des Gehäuses 11 kann von der Bauart des Gehäuses 10 verschieden sein. Zum Beispiel kann das Gehäuse 11 aus mehreren Platten zusammengeschweißt sein. Andere Bauarten sind möglich. Es kann Öffnungen 12, 13, 14 z.B. zum Einführen von Kabeln aufweisen.

Das erfindungsgemäß ausgebildete Gehäuse 10 ist in Figur 2 gesondert veranschaulicht. Es umfasst eine erste Gehäuseschale 15 und eine zweite Gehäuseschale 16, die miteinander verschweißt sind. Die beiden Gehäuseschalen 15, 16 sind zueinander komplementär ausgebildet, so dass sie ineinander greifend einen Innenraum 17 umschließen.

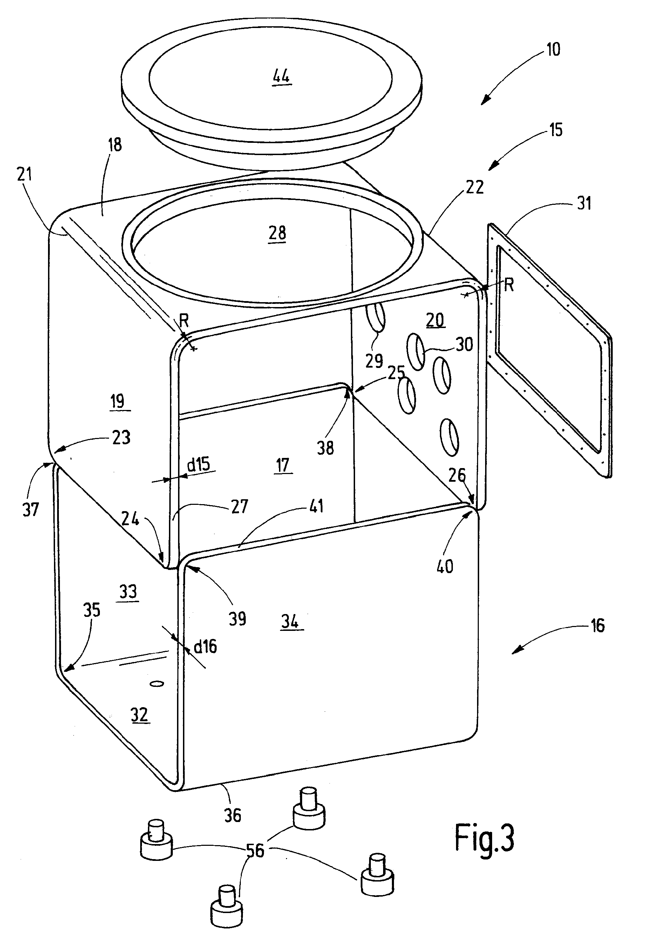

Der weitere Aufbau des Gehäuses 10 und seiner Gehäuseschalen 15, 16 geht aus dem leicht modifizierten in Figur 3 veranschaulichten Ausführungsbeispiel des Gehäuses 10 hervor:
Die erste Gehäuseschale 15 ist einteilig als Blechbiegeteil ausgebildet. Sie umfasst einen im vorliegenden Beispiel rechteckig berandeten Grundabschnitt 18, an den sich zwei Seitenabschnitte 19, 20 anschließen. Zwischen dem Grundabschnitt 18 und den Seitenabschnitten 19,20 sind zueinander parallele Biegezonen 21, 22 ausgebildet, bei denen der Grundabschnitt 18 mit einem gegebenen Biegeradius R in die Seitenabschnitte 19, 20 übergeht. Der Biegeradius R ist vorzugsweise etwas größer als die Wandstärke d15, die z.B. in einem Bereich von 10 mm bis 25 mm liegen kann und im vorliegenden Ausführungsbeispiel 12 mm, 15 mm oder 20 mm beträgt. Der Grundabschnitt 18 und die Seitenabschnitte 19, 20 weisen vorzugsweise eine einheitliche Wandstärke auf.

Die Seitenabschnitte 19, 20 weisen vorzugsweise gerundete Ecken 23, 24, 25, 26 auf. Somit weist die erste Gehäuseschale 15 einen streifenförmigen Rand 27 auf, der sich ringsum entlang der Kanten des Bodenabschnitts 18 und der Seitenabschnitte 19, 20 erstreckt und der keine scharfen Ecken aufweist.

Die Gehäuseschale 15 kann Durchbrüche wie bspw. eine große Öffnung 28 aufweisen, die, wie dargestellt, kreisförmig oder auch gemäß Figur 2 lediglich abschnittsweise gerundet oder in Abwandlung davon rechteckig oder anderweitig polygonal begrenzt ausgebildet sein kann. Vorzugsweise nimmt der Durchbruch 28 einen großen Teil der Fläche des Grundabschnitts 18 ein.

Weitere Durchbrüche 29, 30 können bspw. an dem Seitenabschnitt 20 oder auch an dem Seitenabschnitt 19 vorgesehen sein. Diese Durchbrüche 29, 30 können z.B. als Durchgänge z.B. als Leitungsdurchgänge in das Gehäuse 11 dienen. Zwischen beiden Gehäusen 10, 11 kann die in Figur 3 dargestellte Dichtung 31 angeordnet sein, um die Ausbildung offen stehender Spalte zu vermeiden, die eine Verbindung zwischen dem Innenraum 17 und der Umgebung herstellen könnten.

Die zweite Gehäuseschale 16 ist ähnlich aufgebaut wie die erste Gehäuseschale 15 und komplementär zu dieser. Während die Gehäuseschale 15 in Figur 3 eine U-förmige Seitenansicht mit nach unten weisenden Schenkeln aufweist, weist die zweite Gehäuseschale 16 eine U-förmige Seitenansicht mit nach oben weisenden Schenkeln auf. Die Gehäuseschale 16 wird von einem Grundabschnitt 32 gebildet, an den sich Seitenabschnitte 33, 34 anschließen. Diese gehen an Biegezonen 35, 36 in den Grundabschnitt über. Die Biegezonen 35, 26 wiesen einen Biegradius auf, der vorzugsweise mit den Eckenradien der Ecken 23, 24, 25, 26 übereinstimmt. Umgekehrt weisen die Seitenabschnitte 33, 34, 37, 38, 39, 49 auf, deren Eckenradien mit den Biegeradien R übereinstimmen.

Vorzugsweise stehen die Seitenabschnitte 19, 20 bzw. 33, 34 jeweils in einem rechten Winkel zu dem zugehörigen Grundabschnitt 18 bzw. 32. Damit sind die Seitenabschnitte 19 und 20 parallel zueinander orientiert. Auch die Seitenabschnitte 33, 34 sind vorzugsweise parallel zueinander orientiert. Die Abmessungen der Seitenabschnitte 19, 20, 33, 34 und der Grundabschnitte 18, 32 sind so bemessen, dass die Gehäuseschalen 15, 16 aufeinander zu zusammengeschoben werden können, so dass die Seitenabschnitte 33, 34 die von der Gehäuseschale 15 definierten maulartigen seitlichen Öffnungen schließen, während die Seitenabschnitte 19, 20 die von der Gehäuseschale 16 definierten maulartigen seitlichen Öffnungen schließen. Dabei liegt die Gehäuseschale 16 entlang des gesamten Randes 27 der Gehäuseschale 15 an dieser an.

Die Gehäuseschale 16 weist einen streifenförmigen Rand 41 auf, der der gesamten Kontur der Gehäuseschale 16 folgt und wegen der Rundung der Ecken 37, 38, 39, 40 sowie der Biegezonen 35, 36 frei von Ecken und Spitzen ist. Außerdem ist er in sich geschlossen. Die Gehäuseschale 16 weist sowohl an den Seitenabschnitten 33, 34 wie auch an dem Grundabschnitt 32 eine Wandstärke d16 auf, die mit der Wandstärke d15 übereinstimmen kann. Die kann jedoch vorzugsweise auch geringer als die Wandstärke d15 gewählt sein, insbesondere wenn zur Erzielung der nötigen Druckfestigkeit eine Wandstärke d16 ausreichend ist, die geringer als die Wandstärke d15 ist. Es kann zweckmäßig sein, die Wandstärke d15 größer festzulegen, um an den Durchbrüchen 28, 29, 30 etwaigen vorhandenen Spalten eine Länge zu geben, die die gewünschte Explosionssicherheit erbringt. Die Spalten sind dann so eng und so lang, dass ein Flammendurchschlag nicht erfolgen kann und dass auch keine heißen Partikel durch den Spalt gelangen können.

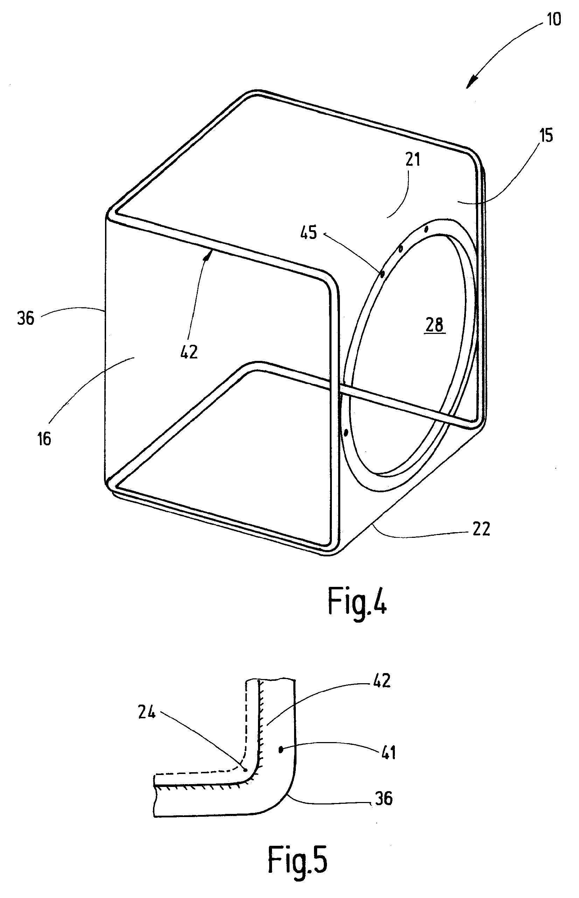

Die beiden Gehäuseschalen 15, 16 sind durch eine Schweißnaht 42 verbunden, die zur besseren Veranschaulichung in Figur 4 als dicke schwarz ausgezogene Kurve dargestellt ist. Wie ersichtlich, ist die Schweißnaht 42 in sich geschlossen, d.h. wo immer mit ihrer Herstellung begonnen worden ist, ist sie absatzlos in einem Zuge gezogen worden bis die Schweißnaht den Anfangspunkt wieder erreicht hat. Sie ist zumindest topologisch ein in sich geschlossener endloser Ring, der allerdings räumlich verformt ist und somit entlang von acht Kanten des von dem Gehäuse 10 gebildeten Quaders läuft. Die übrigen vier Kanten dieses Quaders werden durch die Biegezonen 21, 22 bzw. 35, 36 gebildet.

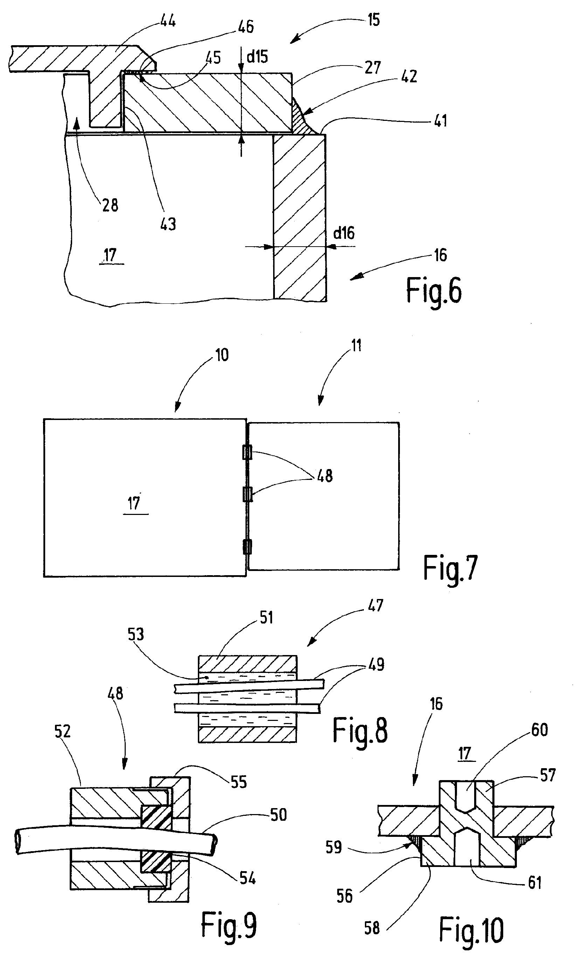

Figur 5 veranschaulicht den Verlauf der Schweißnaht 42 beispielhaft an der Ecke 24 und der Biegezone 36 (siehe auch Figur 2). Wie ersichtlich ist die Ausbildung hier so getroffen, dass die Gehäuseschale 15 auf dem Rand 41 liegt. Die Schweißnaht 42 ist eine Kehlnaht zwischen den Rändern 27, 41. Zur weiteren Veranschaulichung wird auch auf Figur 6 verwiesen, die dies nochmals zeigt. Die Anordnung kann auch dann auf diese Weise getroffen werden, wenn die Wandstärke d16 der Gehäuseschale 16 geringer ist als die Wandstärke d15 der ersten Gehäuseschale 15.

Weiter veranschaulicht Figur 6 einen möglichen Verschluss des Durchbruchs 28. Die Wandung dieses Durchbruchs 28 kann mit einem Gewinde 43 versehen sein, in das ein Deckel 44 eingeschraubt ist. Das Gewinde 43 liefert eine Spaltlänge, die größer ist als die Wandstärke d15. Somit kann eine Spaltlänge von z.B. 20 mm oder 25 mm auch mit Wandstärken d15 erreicht werden, die geringer sind als dieses Maß. Es ist bei dieser wie auch bei allen anderen Ausführungsformen möglich, den Durchbruch 28 mit einem ringsumlaufenden Axialvorsprung, d.h. einem Kragen oder einer Aushalsung zu versehen. Dies gilt auch für die Durchbrüche 29, 30 und ist insbesondere bei geringen Wandstärken zweckmäßig.

Zur weiteren Abdichtung kann zwischen dem Deckel 44 und einer gegebenenfalls fein bearbeiteten den Durchbruch 28 umgebenden ringförmigen Dichtungsfläche eine Dichtung 46 angeordnet sein. Die Dichtungsfläche 45 kann von einer oder mehreren Bohrungen durchbrochen sein, die zur Aufnahme von Sicherungsschrauben, Sicherungsstiften, Befestigungsschrauben oder dergleichen dient. Die Bohrungen sind vorzugsweise Sackbohrungen. Andere Möglichkeiten zum Verschluss des Durchbruchs 28 können vorgesehen sein, wie bspw. ein Kranz von den Durchbruch 28 umgebenden Gewindesackbohrungen zur Befestigung anschraubbarer Deckel oder dergleichen.

Figur 7 veranschaulicht symbolisch die Verbindung zwischen den Gehäusen 10 und 11. Zwischen den beiden Gehäusen 10, 11 können in den Durchbrüchen 29, 30 angeordnete Aderdurchführungen 47 z.B. gemäß Figur 8 oder Kabeldurchführungen 48, z.B. gemäß Figur 9 angeordnet sein. Sie dienen jeweils der Durchführung von Adern 49 oder Kabeln 50, die in einer entsprechenden Buchse 51, 52 durch Verguss 53 oder eine Dichtung 54 gesichert sein können. Die Dichtung 54 kann z.B. durch eine Überwurfmutter 55 am Platz gesichert und unter Axialspannung gesetzt sein, um das Kabel 50 unter Verschluss eines Durchgangsspalts zu fixieren.

Derartige Kabeldurchführungen 48 ermöglichen es, eine vormontierte elektrische oder elektronische Einheit durch den großen Durchbruch 28 in den Innenraum zu führen und dabei elektrische Anschlüsse durch die Durchbrüche 29, 30 und somit die Kabelführungen 48 in das Gehäuse 11 zu schieben, in denen sie dann z.B. von einer Klemmeinrichtung kontaktiert werden.

Vorzugsweise sind alle Durchbrüche, die nicht dicht verschlossen sind, sondern durchschlagsichere Spalte freilassen können, an nur einer Gehäuseschale, hier der Gehäuseschale 15 ausgebildet. Vorzugsweise weist diese mindestens eine Wandstärke d15 auf, die ebenso groß oder größer ist als die Wandstärke d16.

An der Gehäuseschale 16 können Befestigungsmittel, wie bspw. Gerätefüße 56, vorgesehen sein. Diese weisen z.B. einen zylindrischen Körper 57 und einen scheibenförmigen vorzugsweise außenseitig angeordneten Flansch 58 auf. Der Flansch 58 kann mit einer ringförmigen Schweißnaht 59 ringsum mit der Gehäuseschale 16 verscheißt sein. Der Gerätefuß 56 kann sowohl zur Innenseite 17 hin wie auch an der Außenseite mit Gewindebohrungen 60, 61 versehen sein. Diese sind vorzugsweise Sackbohrungen, so dass kein Durchgang geschaffen ist.

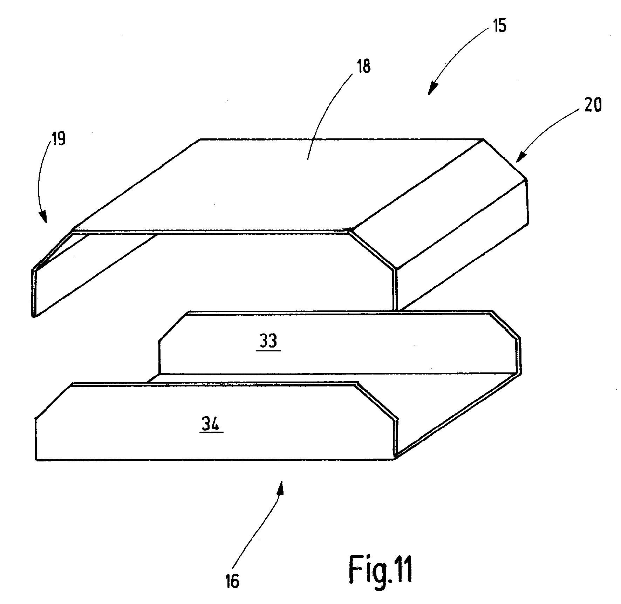

Das Gehäuse 10 ist vorstehend als quaderförmiges Gehäuse beschrieben worden. Wie Figur 11 zeigt, kann es jedoch auch davon abweichende Formen aufweisen, ohne dass das erfindungsgemäße Konzept verlassen werden müsste. Zum Beispiel können die Seitenteile 19, 20 gerundet oder, wie dargestellt, mehrfach abgewinkelt sein. Die Seitenteile 33, 34 haben eine entsprechend angepasste komplementäre Kontur, so dass sie wiederum lückenlos die maulartigen Öffnungen der oberen Gehäuseschale 15 schließen. Die beiden Gehäuseschalen 15, 16 werden wiederum mit einer in sich geschlossenen umlaufenden Schweißnaht geschlossen, um einen Innenraum zu umschließen. Jede der Gehäuseschalen 15, 16 kann Durchbrüche aufweisen. Die vorstehende Beschreibung gilt entsprechend.

Zur Herstellung des Gehäuses 10 wird vorzugsweise von geeignet bereitgestellten Blechzuschnitten ausgegangen. Diese können bspw. im Laserschneidverfahren ausgeschnittene rechteckige Blechzuschnitte mit gerundeten Ecken sein. In einem zweiten Schritt werden die Biegezonen 21, 22 sowie 35, 36 hergestellt. Mit anderen Worten, die Blechrohlinge werden so abgewinkelt, dass die Seitenabschnitte 19, 20 z.B. im rechten Winkel gegen den Grundabschnitt 18 abgewinkelt werden, so dass sie parallel zueinander sind. Gleiches gilt für die Seitenabschnitte 33, 34 und den Grundabschnitt 32.

Im nächsten Schritt werden die Gehäuseschalten 15, 16 ineinander gefügt, so dass die Kante eines Rands, bspw. die innen liegende Kante des Rands 27, auf dem Rand 41 aufliegt. In diesem Zustand kann, z.B. mit einem Schweißautomaten, die entlang des gesamten Rands 41 führende Schweißnaht 42 erzeugt werden.

Falls gewünscht kann das Gehäuse 10 nach Herstellung der Schweißnaht 42 noch einem oder mehreren weiteren Behandlungsschritten unterzogen werden. Z.B. kann das Gehäuse 10 spannungsfrei geglüht werden. Auch kann die mechanische Bearbeitung von Anschlussflächen oder Gewinden, z.B. in den Durchbrüchen 28, 29, 30, nach Erzeugung der Schweißnaht 42 vorgenommen werden.

Zur Herstellung eines druckfesten Gehäuses in der Explosionsschutzart ex-d wird von zwei Blechzuschnitten ausgegangen, die u-förmig abgekantet werden. Sie werden ineinander gefügt, geheftet und anschließend ohne Schweißnahtvorbereitung durch eine umlaufende Kehlnaht zusammengeschweißt.

An einer Seite des Gehäuses 10 ist vorzugsweise ein großer Durchbruch 28 vorgesehen. Dieser kann mit einem Gewindedeckel oder mit einem Flachdeckel verschlossen sein.

### Bezugszeichenliste:

- 10: Gehäuse ex-d
- 11: Gehäuse ex-e
- 12...14: Öffnungen
- 15: erste Gehäuseschale
- 16: zweite Gehäuseschale
- 17: Innenraum
- 18: Grundabschnitt der ersten Gehäuseschale 15
- 19, 20: Seitenabschnitte der ersten Gehäuseschale 15
- 21, 22: Biegezonen
- R: Biegeradius
- d15: Wandstärke
- 23 - 26: Ecke
- 27: Rand
- 28: Durchbruch
- 29, 30: Durchbrüche
- 31: Dichtung
- 32: Grundabschnitt der zweiten Gehäuseschale 16
- 33, 34: Seitenabschnitte der zweiten Gehäuseschale 15
- 35, 36: Biegezonen
- 37 - 40: Ecken
- 41: Rand
- d16: Wandstärke
- 42: Schweißnaht
- 43: Gewinde
- 44: Deckel
- 45: Dichtungsfläche
- 46: Dichtung
- 47: Aderdurchführungen
- 48: Kabeldurchführungen
- 49: Adern
- 50: Kabel
- 51, 52: Buchse
- 53: Verguss
- 54: Dichtung
- 55: Überwurfmutter
- 56: Gerätefuß
- 57: Schaft
- 58: Flansch
- 59: Schweißnaht
- 60, 61: Gewindesackbohrungen

## Patentansprüche

1. Gehäuse (10) der Zündschutzart druckfeste Kapselung (ex-d), zur Einhausung elektrischer Elemente, die Zündquellen sein oder bilden können,
mit zwei ineinandergreifenden Gehäuseschalen (15, 16), die untereinander durch eine in sich geschlossene unverzweigte endlose Schweißnaht (42) verbunden sind wobei das Gehäuse (10) aufweist:
eine erste Gehäuseschale (15), die einen Grundabschnitt (18) und zwei Seitenabschnitte (19, 20) aufweist, die sich an einander gegenüberliegenden Seiten des Grundabschnitts (18) an diesen anschließen und mit diesem einen Winkel einschließen, so dass die beiden Seitenabschnitte (19, 20) dreiseitig umgrenzte erste Maulöffnungen mit einer ersten Form ausbilden,
eine zweite Gehäuseschale (16), die einen Grundabschnitt (32) und zwei Seitenabschnitte (33, 34) aufweist, die sich an einander gegenüberliegenden Seiten des Grundabschnitts (32) an diesen anschließen und mit diesem einen Winkel einschließen, so dass die beiden Seitenabschnitte (33, 34) dreiseitig umgrenzte Maulöffnungen mit einer zweiten Form ausbilden,
wobei die beiden Gehäuseschalen (15, 16) mit ihren Seitenabschnitten (19, 20; 33, 34) ineinandergreifend so angeordnet sind, dass die Seitenabschnitte (19, 20) der ersten Gehäuseschale (15) die Maulöffnungen der zweiten Gehäuseschale (16) und die Seitenabschnitte (33, 34) der zweiten Gehäuseschale (16) die Maulöffnungen der ersten Gehäuseschale (15) schließen,
**dadurch gekennzeichnet, dass** die Ränder (27, 41) beieinander liegen und wobei sich die Schweißnaht (42) entlang der beiden Ränder (27, 41) über deren gesamte Länge gesamten lückenlos erstreckt wobei die zweite Gehäuseschale (16) als Rand (41) eine streifenförmige Stirnfläche aufweist, die von der ersten Gehäuseschale (15) wenigstens teilweise übergriffen ist, oder die erste Gehäuseschale (15) als Rand (27) eine streifenförmige Stirnfläche aufweist, die von der zweiten Gehäuseschale (16) wenigstens teilweise übergriffen ist,
wobei die Schweißnaht (42) als Kehlnaht zwischen dem Rand (27) der ersten Gehäuseschale (15) und dem Rand (41) der zweiten Gehäuseschale (16) ausgebildet ist.

2. Gehäuse nach Anspruch 1, **dadurch gekennzeichnet, dass** die Seitenabschnitte (19, 20; 33, 34) gerundete Ecken aufweisen.

3. Gehäuse nach Anspruch 1, **dadurch gekennzeichnet, dass** die Grundabschnitte (18, 32) der Gehäuseschalen (15, 16) jeweils mit einer gerundeten Biegezone (21, 22; 35, 36) in die Seitenabschnitte (19, 20; 33, 34) übergehen.

4. Gehäuse nach Anspruch 2 und 3, **dadurch gekennzeichnet, dass** die gerundeten Biegezonen (21, 22) der einen Gehäuseschale (15) jeweils eine Zylinderkrümmung aufweisen, die mit der Rundung der jeweils anliegenden Ecke (37, 38, 39, 40) der anderen Gehäuseschale (16) übereinstimmt.

5. Gehäuse nach Anspruch 1, **dadurch gekennzeichnet, dass** die Gehäuseschalen (15, 16) übereinstimmende Wandstärken (d15, d16) aufweisen.

6. Gehäuse nach Anspruch 1 oder 5, **dadurch gekennzeichnet, dass** eine der Gehäuseschalen (15, 16) mindesten einen von einem Deckel (44) verschlossenen Durchbruch (28) aufweist.

7. Gehäuse nach Anspruch 6, **dadurch gekennzeichnet, dass** weitere einen Spalt festlegende Durchbrüche (29, 30) ausschließlich in derjenigen der beiden Gehäuseschalen (15, 16) ausgebildet sind, die den Durchbruch (28) enthält.

8. Gehäuse nach Anspruch 1, **dadurch gekennzeichnet, dass** es mit einem Gehäuse (11) der Schutzart ex-e verbunden ist.

9. Gehäuse nach Anspruch 7 und 8, **dadurch gekennzeichnet, dass** in den Durchbrüchen (29, 30) Aderdurchführungen (47) und/oder Kabeldurchführungen (48) angeordnet sind.

10. Gehäuse nach Anspruch 8, **dadurch gekennzeichnet, dass** das Gehäuse (11) der Zündschutzart erhöhte Sicherheit (ex-e) als Metall- oder Kunststoffgehäuse ausgebildet und mit dem Gehäuse (10) verschraubt ist.

11. Verfahren zur Herstellung von Gehäusen (10) der Zündschutzart druckfeste Kapselung (ex-d), zur Einhausung elektrischer Elemente, die Zündquellen sein oder bilden können, mit folgenden Schritten:
Bereitstellung einer erste Gehäuseschale (15), indem ein erster Blechzuschnitt entlang zweier gerader Biegelinien (21, 22) mit definiertem Radius (R) abgewinkelt wird,
Bereitstellung einer zweiten Gehäuseschale (16), indem ein zweiter Blechzuschnitt entlang zweier Biegelinien (35, 36) mit definiertem Radius abgewinkelt wird,
Zusammenfügen der beiden Gehäuseschalen (15, 16), so dass die abgewinkelten Abschnitte einer der beiden Gehäuseschalen (15, 16) in den Zwischenraum zwischen den abgewinkelten Abschnitten der anderen der Gehäuseschalen (15, 16) greifen,
Ausbilden einer geschlossenen unverzweigten endlosen Schweißnaht (42) entlang des gesamten Rands der beiden Blechzuschnitte, **dadurch gekennzeichnet, dass** die Schweißnaht (42) in einem Zug ohne abzusetzen ausgebildet wird.

## Claims

1. Housing (10) with pressure-resistant enclosure (ex-d) type ignition protection for housing electrical elements which may be or may form sources of ignition,
having two housing shells (15, 16) engaging with each other, which are connected to each other by a self-contained, unbranched, continuous welded seam (42), wherein the housing (10) has:
a first housing shell (15) which has a base section (18) and two side sections (19, 20) which are connected to this on sides of the base section (18) which face one another and form an angle with this, such that the two side sections (19, 20) form first jaw openings delimited on three sides, having a first shape,
a second housing shell (16) which has a base section (32) and two side sections (33, 34) which are connected to this on sides of the base section (32) which face one another and form an angle with this, such that the two side sections (33, 34) form jaw openings delimited on three sides, having a second shape,
wherein the two housing shells (15, 16) are arranged with their side sections (19, 20; 33, 34) engaging with one another in such a way that the side sections (19, 20) of the first housing shell (15) close the jaw openings of the second housing shell (16) and the side sections (33, 34) of the second housing shell (16) close the jaw openings of the first housing shell (15),
**characterised in that**
the edges (27, 41) are close together and wherein the welded seam (42) extends along the two edges (27, 41) over the whole length thereof with no gaps, wherein the second housing shell (16) has a strip-like front surface as an edge (41), said front surface being at least partially overlapped by the first housing shell (15), or the first housing shell (15) has a strip-like front surface as an edge (27), said front surface being at least partially overlapped by the second housing shell (16),
wherein the welded seam (42) is formed as a fillet weld between the edge (27) of the first housing shell (15) and the edge (41) of the second housing shell (16).

2. Housing according to claim 1, **characterised in that** the side sections (19, 20; 33, 34) have rounded corners.

3. Housing according to claim 1, **characterised in that** the base sections (18, 32) of the housing shells (15, 16), each having a rounded bending zone (21, 22; 35, 36), pass into the side sections (19, 20; 33, 34).

4. Housing according to claim 2 and 3, **characterised in that** the rounded bending zones (21, 22) of one housing shell (15) each have a cylindrical curvature which corresponds to the curvature of the respective adjacent corner (37, 38, 39, 40) of the other housing shell (16).

5. Housing according to claim 1, **characterised in that** the housing shells (15, 16) have consistent wall thicknesses (d15, d16).

6. Housing according to claim 1 or 5, **characterised in that** one of the housing shells (15, 16) has at least one opening (28) which is closed by a cover (44).

7. Housing according to claim 6, **characterised in that** further openings (29, 30) determining a gap are only formed in the housing shell (15, 16) which contains the opening (28).

8. Housing according to claim 1, **characterised in that** it is connected to a housing (11) with ex-e type protection.

9. Housing according to claim 7 and 8, **characterised in that** wire feedthroughs (47) and/or cable feedthroughs (48) are arranged in the openings (29, 30).

10. Housing according to claim 8, **characterised in that** the housing (11) with increased safety (ex-e) type ignition protection is formed as a metal or plastic housing and is screwed to the housing (10).

11. Method for the production of housings (10) with pressure-resistant enclosure (ex-d) type ignition protection for housing electrical elements which may be or may form sources of ignition, having the following steps:
preparing a first housing shell (15), wherein a first sheet metal blank is angled with a defined radius (R) along two straight bending lines (21, 22),
preparing a second housing shell (16), wherein a second sheet metal blank is angled with a defined radius along two bending lines (35, 36),
assembling the two housing shells (15, 16) such that the angled sections of one of the two housing shells (15, 16) engage in the intermediate space between the angled sections of the other of the housing shells (15, 16),
forming a closed, unbranched, continuous welded seam (42) along the whole edge of the two sheet metal blanks, **characterised in that** the welded seam (42) is formed in one go without stopping.

## Revendications

1. Coffret (10) de la classe de protection Enveloppe résistante à la pression (ex-d) pour abriter des éléments électriques qui peuvent être ou créer des sources d'inflammation,
comprenant deux coques de coffret (15, 16) qui sont reliées entre elles par l'intermédiaire d'un cordon de soudure fermé en soi, sans ramification et sans fin (42), le coffret (10) comportant :
une première coque de coffret (15) qui comporte une portion de fond (18) et deux portions de côtés (19, 20) qui se raccordent à la portion de fond (18) au niveau de côtés opposés de celle-ci et incluent avec celle-ci un angle, de façon que les deux portions de côtés (19, 20) déterminent des premières ouvertures emboîtantes entourées sur trois côtés, avec une première forme,
une seconde coque de coffret (16) qui comporte une portion de fond (32) et deux portions de côtés (33, 34) qui se raccordent à la portion de fond (32) au niveau de côtés opposés de celle-ci et incluent avec celle-ci un angle, de sorte que les deux portions de côtés (33, 34) déterminent des ouvertures emboîtantes entourées sur trois côtés, avec une seconde forme,
les deux coques de coffret (15, 16) étant conçues de manière emboîtante par leurs portions de côtés (19, 20 ; 33, 34), de façon que les portions de côtés (19, 20) de la première coque de coffret (15) ferment les ouvertures emboîtantes de la seconde coque de coffret (16), et que les portions de côtés (33, 34) de la seconde coque de coffret (16) ferment les ouvertures emboîtantes de la première coque de coffret (15),
**caractérisé en ce que** les bords (27, 41) sont accolés, le cordon de soudure (42) s'étendant le long des deux bords (27, 41) sur toute leur longueur de façon ininterrompue, la seconde coque de coffret (16) présentant en tant que bord (41) une face frontale en forme de bande qui est au moins partiellement recouverte par la première coque de coffret (15), ou la première coque de coffret (15) présentant en tant que bord (27) une face frontale en forme de bande qui est au moins partiellement recouverte par la seconde coque de coffret (16), le cordon de soudure (42) étant conformé en soudure d'angle entre le bord (27) de la première coque de coffret (15) et le bord (41) de la seconde coque de coffret (16).

2. Coffret selon la revendication 1, **caractérisé en ce que** les portions de côtés (19, 20 ; 33, 34) présentent des coins arrondis.

3. Coffret selon la revendication 1, **caractérisé en ce que** les portions de fond (18, 32) des coques de coffret (15, 16) rejoignent chacune les portions de côtés (19, 20 ; 33, 34) par l'intermédiaire d'une zone de pliage arrondie (21, 22 ; 35, 36).

4. Coffret selon la revendication 2 et 3, **caractérisé en ce que** les zones de pliage arrondies (21, 22) de l'une des coques de coffret (15) présentent chacune une courbure cylindrique qui coïncide avec l'arrondi du coin adjacent correspondant (37, 38, 39, 40) de l'autre coque de coffret (16).

5. Coffret selon la revendication 1, **caractérisé en ce que** les coques de coffret (15, 16) présentent des épaisseurs de paroi (d15, d16) concordantes.

6. Coffret selon la revendication 1 ou 5, **caractérisé en ce qu'**une des coques de coffret (15, 16) présente au moins un passage (28) fermé par un couvercle (44).

7. Coffret selon la revendication 6, **caractérisé en ce que** d'autres passages (29, 30) déterminant un interstice sont ménagés exclusivement dans celle des deux coques de coffret (15, 16) pourvue du passage (28).

8. Coffret selon la revendication 1, **caractérisé en ce qu'**il est relié à un coffret (11) de la classe de protection ex-e.

9. Coffret selon la revendication 7 et 8, **caractérisé en ce que** dans les passages (29, 30) sont ménagées des traversées de conducteurs (47) et/ou des traversées de câbles (48).

10. Coffret selon la revendication 8, **caractérisé en ce que** le coffret (11) de la classe de protection Sécurité accrue (ex-e) est conformé en coffret en métal ou en matière synthétique et est vissé avec le coffret (10).

11. Procédé de fabrication de coffrets (10) de la classe de protection Enveloppe résistante à la pression (ex-d) pour abriter des éléments électriques qui peuvent être ou créer des sources d'inflammation, comprenant les étapes suivantes :
fourniture d'une première coque de coffret (15), une première pièce en tôle découpée étant pliée selon un rayon défini (R) le long de deux lignes de pliage rectilignes (21, 22),
fourniture d'une seconde coque de coffret (16), une seconde pièce en tôle découpée étant pliée selon un rayon défini le long de deux lignes de pliage (35, 36),
assemblage des deux coques de coffret (15, 16), de façon que les portions pliées de l'une des deux coques de coffret (15, 16) s'insèrent dans l'intervalle compris entre les portions pliées de l'autre des coques de coffret (15, 16),
réalisation d'un cordon de soudure fermé, sans ramification et sans fin (42) le long de la totalité du bord des deux pièces en tôle découpée, **caractérisé en ce que** le cordon de soudure (42) est réalisé en une passe sans interruption.
